# EUROPEAN PATENT APPLICATION

(11) **EP 4 729 959 A1**
(43) Date of publication of application: **22.04.2026**
(21) Application number: 24207125.6
(22) Date of filing: 17.10.2024
(51) Int. Cl.: G01R 31/367, G01R 31/3835, G01R 31/392

(54) **A METHOD FOR DEGRADATION DIAGNOSIS OF A DEGRADED BATTERY CELL**

(71) Applicant: Polestar Performance AB, 405 31 Gothenburg (SE)
(72) Inventor: FLORES CHACON, Alejandro Andres, 1061 Caracas (VE); PETISME, Martin Ventura Gustav, 433 75 Jonsered (SE); GROOT, Jens Olof David, 463 96 Nygård (SE)
(74) Representative: Zacco Sweden AB

(57) **Abstract**

The disclosed technology relates to a computer-implemented method (100), and device (200) thereof, for degradation diagnosis of a degraded battery cell. The method (100) comprises: obtaining (5102) information indicative of a voltage response of the degraded battery cell; obtaining (5104) information indicative of a voltage response of a pristine battery cell, wherein the degraded battery cell and the pristine battery cell is of a same battery specification; processing (5106) the information indicative of the voltage response of the degraded battery cell through a one-dimensional convolutional neural network, thereby generating a first output; processing (S108) the information indicative of the voltage response of the pristine battery cell through the one-dimensional convolutional neural network, thereby generating a second output; forming (S110) a difference between the first output and the second output; and determining (5112) degradation data indicative of a degradation of the degraded battery cell by processing said difference through a mathematical model, wherein the mathematical model is configured to process data of input differences between a first battery cell and a second battery cell, and to generate degradation data of the first battery cell as output.

## Description

### TECHNICAL FIELD

The disclosed technology relates to the field of battery diagnosis, and in particular to a method, device and computer program product for non-destructive degradation diagnosis of a degraded battery cell.

### BACKGROUND

With the continuous integration of renewable energy and the increasing electrification in recent years, the importance and the use of batteries have grown significantly. Currently, Li-ion batteries dominate the market, ranging from large-scale energy storage facilities used for grid services to electric vehicles and everyday electronic devices. Optimizing the design, usage, and diagnosis of this technology is crucial for the energy transition.

Batteries inevitably suffer from irreversible degradation over time, such as capacity loss and increased impedance. Particularly in the electric vehicle industry, accurate and reliable diagnosis, and ideally prognosis of battery health is essential. In this context, increased age leads to reduced range, power output, precision of state of charge (SOC) estimation, and potential safety hazards. However, this task is challenging due to the complex and varied degradation phenomena within battery cells, which are highly dependent on factors such as temperature, charge/discharge rates, and usage patterns, which leads to nonlinear and battery-individual degradation patterns. Furthermore, the specific chemistry of the electrodes and other design choices fundamentally affect the aging behaviour of the cell.

Currently, state of health (SOH) estimation in EVs primarily relies on empirical methods that track capacity loss and resistance increase, but these methods provide no insight into the specific types of degradation occurring within the cell nor their root causes. More sophisticated techniques, such as electrochemical impedance spectroscopy or destructive post-mortem analysis, offer detailed insights but are not viable for large-scale industrial applications nor for products in circulation.

There is therefore a need for new and improved ways of estimating battery degradation, that can be performed in real-time, while offering precise and efficient monitoring without compromising the integrity of the battery. Moreover, it should provide detailed insights into the internal phenomena of the battery cell. This can promote further optimization of battery usage, design, and prognosis. More precise diagnostics can also improve the assessment of battery states at the end of an EV's life and enhance second-life usage of the batteries, promoting recyclability and environmental care.

### SUMMARY

The herein disclosed technology seeks to mitigate, alleviate or eliminate one or more of the above-identified deficiencies and disadvantages in the prior art to address various problems relating to battery diagnosis. There are several factors affecting the degradation of a battery cell, such as number of charge/discharge cycles, charge rate, temperature, and loss of material in the battery cell. Modelling the degradation is therefore not a simple task. The inventors have realized a new and improved way of performing non-destructive degradation diagnosis of a degraded battery cell. The disclosed technology provides an efficient and accurate method for estimating the degradation of a battery cell, which offers good generalizability (i.e. working for several battery types) as well as feature extraction in a more automated manner. It partly builds upon a model architecture which is more robust and less susceptible to cell variations, as well as reduced complexity compared to existing solutions. Moreover, the model is capable of quantifying and characterizing degradation modes within the cell. The disclosed technology focuses on utilizing the cell voltage response and derivative techniques, such as incremental capacity, along with battery modelling and synthetic data, as tools to employ data-driven methods, specifically machine learning algorithms, for cell degradation diagnosis. Although the disclosed technology is mainly described in the context of electric vehicles, it also finds applicability in other battery applications.

Various aspects and embodiments of the disclosed technology are defined below and in the accompanying independent and dependent claims.

According to a first aspect, there is provided a computer-implemented method for degradation diagnosis of a degraded battery cell. The method comprises obtaining information indicative of a voltage response of the degraded battery cell. The method further comprises obtaining information indicative of a voltage response of a pristine battery cell. The degraded battery cell and the pristine battery cell is of a same battery specification. The method further comprises processing the information indicative of the voltage response of the degraded battery cell through a one-dimensional convolutional neural network, thereby generating a first output. The method further comprises processing the information indicative of the voltage response of the pristine battery cell through the one-dimensional convolutional neural network, thereby generating a second output. The method further comprises forming a difference between the first output and the second output. The method further comprises determining degradation data indicative of a degradation of the degraded battery cell by processing said difference through a mathematical model. The mathematical model is configured to process data of input differences between a first battery cell and a second battery cell, and to generate degradation data of the first battery cell as output.

As explained in the foregoing, the proposed method has been found to outperform (e.g. in terms of lower error and higher accuracy) similar models and architectures, while also achieving better generalization of degradation analysis for different cell configurations within a chemistry type. Moreover, this can all be done while using a less complex model architecture, which can save on computational resources, and make the process more efficient in terms of time-savings. This can be linked at least partly to the use of a 1D convolutional neural network, which is applied to both degraded and healthy voltage responses, to extract relevant features in the responses. In combination with a mathematical model operating on the difference between the processed voltage responses, the model effectively learns and extract information from the change in the features of relevance, rather than memorizing the degradation of each specific voltage response. This is shown by the model's ability to accurately generalize and to maintain consistent performance across various cell configurations. In other words, by having the mathematical model work on the difference between degraded and healthy voltage response, it is not limited to a specific cell configuration, but can process differences formed between voltage responses of any cell specification, as long as it is given a degraded voltage response and a healthy voltage response from battery cells of the same specification. Furthermore, this new approach achieved such generalization capabilities with fewer trainable parameters, producing a compact model with fewer parameters than the state-of-the-art models designed for similar applications.

Overall, this method can open the door for better future implementations of degradation mode tracking. The use of incremental capacity (or other voltage response) as input allows for possible diagnosis of actively used applications, such as electric vehicles. Additionally, the model's generalization capabilities suggest that as long as the electrode chemistry remains the same, retraining the model or adjusting the algorithm would not be required to account for variations in production batches, models, or even different manufacturers. This reduces the need for expensive, time-consuming expert analysis, as there is no requirement to manually track features of interest or to adjust the model for each specific specification. Furthermore, the risk of loss in accuracy due to improper cell modelling is minimized, as the model does not need to be trained on the exact cell specification intended for diagnosis, but only on a cell with the same electrode chemistry.

The one-dimensional convolutional neural network may comprise two or more convolutional layers. A possible associated advantage of having more than one convolutional layer is that it can be made more robust, and better at detecting relevant features in the input data of various sizes. In other words, this can facilitate better extraction of relevant features from the data input to the convolutional neural network.

The voltage response of the degraded battery cell may be processed through each of the two or more convolutional layers, thereby generating a respective first sub-output. The first output may be a combined output of the respective first sub-outputs from the two or more convolutional layers.

The voltage response of the pristine battery cell may be processed through each of the two or more convolutional layers, thereby generating a respective second sub-output. The second output may be a combined output of the respective second sub-outputs from the two or more convolutional layers.

The difference may be formed by element-wise subtraction between the first output and the second output.

The mathematical model may be a machine learning model. A possible associated advantage is that this can facilitate automatic identification of features of relevance, which may lead to improved accuracy of the generated predictions.

The mathematical model may be a neural network. The neural network may comprise an input layer, one or more fully connected layers, and an output layer.

The mathematical model may be configured to process data of battery cells having different cell configurations within a certain chemistry type. This may be advantageous in that it can allow the model to generalize across variations of cell configurations, without needing to be retrained.

The one-dimensional convolutional neural network and the mathematical model may be trained together in an end-to-end manner. This may lead e.g. to improved feature learning, joint optimization and adaption to diverse data, which in turn leads to more accurate predictions and improved performance.

The degradation data may be indicative of a state of health of the degraded battery cell. The state of health may provide for an easy to understand assessment of the degraded battery cell.

The degradation data may be indicative of one or more aging modes of the degraded battery cell. The aging modes may facilitate more detailed analysis of the degraded battery cell, as it provides information underlying different degradation aspects.

The one or more aging modes may comprise (i) an amount of lost active anode material, (ii) an amount of lost cathode material, and (iii) an amount of lost lithium inventory.

The method may further comprise providing the determined degradation data to a downstream task. Through better estimation of the degradation data, as achieved by the disclosed technology, also the results of the downstream task may be improved.

According to a second aspect, there is provided a computer program product comprising instructions which when the program is executed by a computing device, causes the computing device to carry out the method according to the first aspect. According to an alternative embodiment of the second aspect, there is provided a (non-transitory) computer-readable storage medium. The non-transitory computer-readable storage medium stores one or more programs configured to be executed by one or more processors of a processing system, the one or more programs comprising instructions for performing the method according to the first aspect. With this aspect of the disclosed technology, similar advantages and preferred features are present as in the other aspects.

The term "non-transitory," as used herein, is intended to describe a computer-readable storage medium (or "memory") excluding propagating electromagnetic signals, but are not intended to otherwise limit the type of physical computer-readable storage device that is encompassed by the phrase computer-readable medium or memory. For instance, the terms "non-transitory computer readable medium" or "tangible memory" are intended to encompass types of storage devices that do not necessarily store information permanently, including for example, random access memory (RAM). Program instructions and data stored on a tangible computer-accessible storage medium in non-transitory form may further be transmitted by transmission media or signals such as electrical, electromagnetic, or digital signals, which may be conveyed via a communication medium such as a network and/or a wireless link. Thus, the term "non-transitory", as used herein, is a limitation of the medium itself (i.e., tangible, not a signal) as opposed to a limitation on data storage persistency (e.g., RAM vs. ROM).

According to a third aspect, there is provided a device for degradation diagnosis of a degraded battery cell. The device comprises control circuitry. The control circuitry is configured to obtain information indicative of a voltage response of the degraded battery cell. The control circuitry is further configured to obtain information indicative of a voltage response of a pristine battery cell. The degraded battery cell and the pristine battery cell is of a same battery specification. The control circuitry is further configured to process the information indicative of the voltage response of the degraded battery cell through a one-dimensional convolutional neural network, thereby generating a first output. The control circuitry is further configured to process the information indicative of the voltage response of the pristine battery cell through the one-dimensional convolutional neural network, thereby generating a second output. The control circuitry is further configured to form a difference between the first output and the second output. The control circuitry is further configured to determine degradation data indicative of a degradation of the degraded battery cell by processing said difference through a mathematical model. The mathematical model is configured to process data of input differences between a first battery cell and a second battery cell, and to generate degradation data of the first battery cell as output. With this aspect of the disclosed technology, similar advantages and preferred features are present as in the other aspects.

The disclosed aspects and preferred embodiments may be suitably combined with each other in any manner apparent to anyone of ordinary skill in the art, such that one or more features or embodiments disclosed in relation to one aspect may also be considered to be disclosed in relation to another aspect or embodiment of another aspect.

Further embodiments are defined in the dependent claims. These and other features and advantages of the disclosed technology will in the following be further clarified with reference to the embodiments and variants described hereinafter.

### BRIEF DESCRIPTION OF THE DRAWINGS

The above aspects, features and advantages of the disclosed technology, will be more fully appreciated by reference to the following illustrative and non-limiting detailed description of example embodiments of the present disclosure, when taken in conjunction with the accompanying drawings, in which:
Figure 1 is a schematic flowchart representation of a computer-implemented method for degradation diagnosis of a degraded battery cell, in accordance with some embodiments;
Figure 2 is a schematic illustration of a device for degradation diagnosis of a degraded battery cell, in accordance with some embodiments; and
Figure 3 illustrates, by way of example, an architecture of a model, in accordance with some embodiments.

### DETAILED DESCRIPTION

The present disclosure will now be described in detail with reference to the accompanying drawings, in which some example embodiments of the disclosed technology are shown. The disclosed technology may, however, be embodied in other forms and should not be construed as limited to the disclosed example embodiments. The disclosed example embodiments are provided to fully convey the scope of the disclosed technology to the skilled person. Those skilled in the art will appreciate that the steps, services and functions explained herein may be implemented using individual hardware circuitry, using software functioning in conjunction with a programmed microprocessor or general-purpose computer, using one or more Application Specific Integrated Circuits (ASICs), using one or more Field Programmable Gate Arrays (FPGA) and/or using one or more Digital Signal Processors (DSPs).

It will also be appreciated that when the present disclosure is described in terms of a method, it may also be embodied in apparatus or device comprising one or more processors, one or more memories coupled to the one or more processors, where computer code is loaded to implement the method. For example, the one or more memories may store one or more computer programs that causes the apparatus to perform the steps, services and functions disclosed herein when executed by the one or more processors in some embodiments.

It will also be appreciated that when the present disclosure is described in terms of a method, it may also be embodied in apparatus comprising one or more processors, one or more memories coupled to the one or more processors, where computer code is loaded to implement the method. For example, the one or more memories may store one or more computer programs that causes the apparatus to perform the steps, services and functions disclosed herein when executed by the one or more processors in some embodiments.

It is also to be understood that the terminology used herein is for purpose of describing particular embodiments only, and is not intended to be limiting. It should be noted that, as used in the specification and the appended claim, the articles "a", "an", "the", and "said" are intended to mean that there are one or more of the elements unless the context clearly dictates otherwise. Thus, for example, reference to "a unit" or "the unit" may refer to more than one unit in some contexts, and the like. Furthermore, the words "comprising", "including", "containing" do not exclude other elements or steps. It should be emphasized that the term "comprises/comprising" when used in this specification is taken to specify the presence of stated features, integers, steps, or components. It does not preclude the presence or addition of one or more other features, integers, steps, components, or groups thereof. The term "and/or" is to be interpreted as meaning "both" as well and each as an alternative. More specifically, the wording "one or more" of a set of elements (as in "one or more of A, Band C" or "at least one of A, B and C") is to be interpreted as either a conjunctive or disjunctive logic. Put differently, it may refer either to all elements, one element or combination of two or more elements of a set of elements. For example, the wording "A, B and C" may be interpreted as A or B or C, A and B and C, A and B, B and C, or A and C.

It will also be understood that, although the term first, second, etc. may be used herein to describe various elements or features, these elements should not be limited by these terms. These terms are only used to distinguish one element from another. For example, a first output could be termed a second output, and, similarly, a second output could be termed a first output, without departing from the scope of the embodiments. The first output and the second output are both outputs, but they are not the same output, unless stated otherwise.

Throughout the present disclosure, reference is made to machine learning models. By this, it is herein meant any form of machine learning algorithm, such as deep learning models, neural networks, or the like, which is able to learn and adapt from input data and subsequently make predictions, decisions, or classifications based on new data. Deployment of a machine learning model typically involves a training phase where the model learns from labeled or unlabeled training data to achieve accurate predictions during the subsequent inference phase. In general, the training data (and input data during inference) can e.g. be image data, numerical data, text data, or any other form of data, depending on the task and the model's architecture. Furthermore, the training/input data may comprise a combination or fusion of one or more different data types. The machine learning model may be implemented in some embodiments using publicly available suitable software development machine learning code elements, for example, such as those which are available in Pytorch, TensorFlow, and Keras, or in any other suitable software development platform, in any manner known to be suitable to someone of ordinary skill in the art.

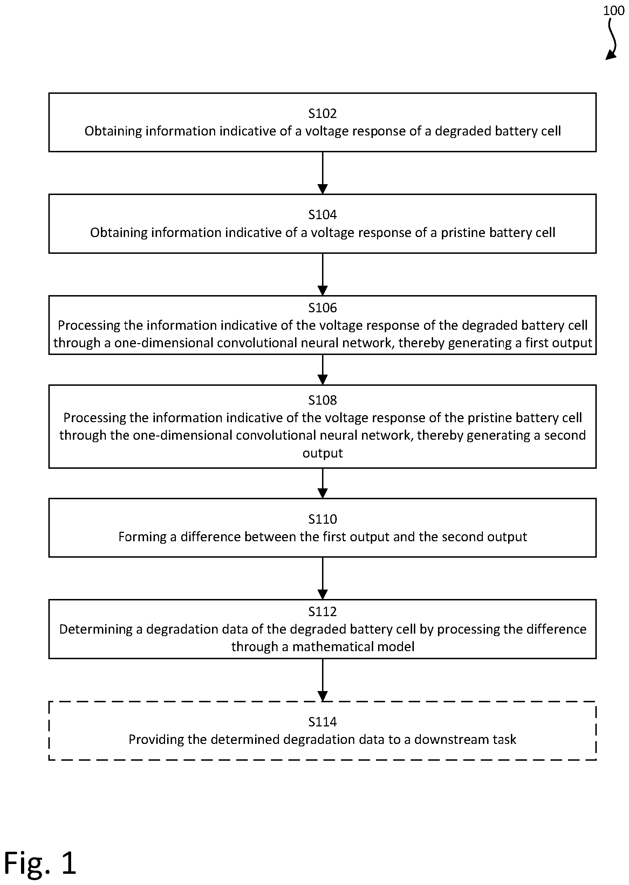

Figure 1 is a schematic flowchart representation of a computer-implemented method 100 for degradation diagnosis of a degraded battery cell. The battery cell may be a lithium-ion (li-ion) battery cell. Put differently, the method 100 may serve to perform analysis of the degraded battery cell, e.g. to determine one or more properties associated with battery degradation. As will be further elaborated upon, such properties may e.g. be a state of health, one or more aging modes of the battery cell, a remaining useful lifetime or the like. The properties may be current properties of the battery cell. In other words, the degradation diagnosis may involve determining (or estimating) properties of the battery cell in its present state. For example, a current state of health. Alternatively, or in combination, the properties may be future (or predicted) properties of the battery cell. In other words, the degradation diagnosis may involve a forecast or prognosis of a future state of the battery cell. For example, a predicted end-of-lifetime or an expected future degradation pattern.

In the following, reference will be made to a "degraded battery cell" and a "pristine battery cell". The degraded battery cell herein refers to the battery cell to be diagnosed/analysed. The degraded battery cell may also be referred to as an "aged battery cell" or a "used battery cell". In other words, the degraded battery cell refers to a battery cell which suffer from some degree of degradation (e.g. in capacity reduction, reduced lifetime or the like) which is to be assessed/estimated. In contrast, the wording "pristine battery cell" refers to a battery cell which has not suffered any noticeable or significant degradation. The pristine battery cell may also be referred to as a "new battery cell" or an "unused battery cell". The pristine battery cell may thus be understood as a battery cell in its original (or pristine) condition (i.e. before use), without any (or at least with very few) signs of wear or degradation. The pristine battery cell can thus serve as a reference point of how the battery cell was before put in use.

Below, the different steps of the method 100 are described in more detail. Even though illustrated in a specific order, the steps of the method 100 may be performed in any suitable order as well as multiple times. Thus, although Fig. 1 may show a specific order of method steps, the order of the steps may differ from what is depicted. In addition, two or more steps may be performed concurrently or with partial concurrence. For example, the steps denoted S102 and S104 may be performed in any order based on a specific realization, as well at a same time. The same may also hold for the steps denoted S106 and S108. Such variation will depend on the software and hardware systems chosen and on designer choice. All such variations are within the scope of the present inventive concept. Likewise, software implementations could be accomplished with standard programming techniques with rule-based logic and other logic to accomplish the various steps. Further variants of the method 100 will become apparent from the present disclosure. The herein mentioned and described embodiments are only given as examples and should not be limiting to the present invention. Other solutions, uses, objectives, and functions within the scope of the invention as claimed below described patent claims should be apparent for the person skilled in the art. It should be appreciated that the method 100 of Fig. 1 comprises some steps which are illustrated as boxes in solid lines and some steps which are illustrated in dashed lines. The steps which are shown in solid lines are steps which are comprised in the broadest example embodiment of the method 100. The steps which are comprised in dashed lines are examples of a number of optional steps which may form part of a number of alternative embodiments.

The method 100 comprises obtaining S102 information indicative of a voltage response of the degraded battery cell. The information indicative of the voltage response of the degraded battery cell may also be referred to as "degraded voltage response", for ease of reference.

The term voltage response herein refers to how the potential of the battery cell varies during its operation, either during charging or discharging. This response can be delimited by the cut-off voltages for each battery cell, but the specific behavior depends on each chemistry type, current rate used, direction of the current, temperature, and battery state of health. The voltage response of a battery provides information about the condition and composition of the cells, acting as a unique electrochemical fingerprint of its chemistry and characteristics. The shape of the voltage response profile of the cell can be influenced by the combined impact of both electrodes, their respective matching, and the ratio between their capacities. In this regard, degradation mechanisms, such as the loss of active material on the electrode, can be monitored. Positions of plateaus in the response depend on the electrode's capacity, and any loss of active material will reduce this capacity. As a result, the plateaus will shift to different states of charge providing insights into the health of the electrode over time.

As used herein, the wording "information indicative of" shall be construed as any information or data from which something can be inferred or derived. In the example of voltage response, the information indicative of the voltage response may thus encompass any direct or indirect information from which the voltage response can be deduced, or in any other way associated with the voltage response. This could include measurements, parameters or other relevant information that may not directly show the voltage response itself, but provides necessary details to calculate, predict or derive (e.g. through further processing) the voltage response. It is however to be noted that the information indicative of the voltage response (as an example), may also comprise the voltage response directly.

In the specific case of voltage response, this information may comprise any quantities containing information related to the voltage response, or directly measured properties. For example, the information indicative of the voltage response may comprise a differential capacity (or incremental capacity), i.e. the capacity derivative with respect to voltage. However, any signal related to features in the voltage signal could in principle be used.

The term "obtaining" is throughout the present disclosure to be interpreted broadly and encompasses receiving, retrieving, collecting, acquiring, measuring and so forth directly and/or indirectly between two entities configured to be in communication with each other or further with other external entities. However, in some embodiments, the term "obtaining" is to be construed as determining, deriving, forming, computing, etc.

In the context of the step denoted S102 above, the information indicative of the voltage response of the degraded battery cell may be obtained e.g. by measurements (or retrieved from an intermediate storage at which earlier measurements have been stored) on the degraded battery cell during charging and/or discharging. Any known procedure for acquiring a voltage response of a battery cell may be used, as realized by the person skilled in the art. As an example, the voltage response may be obtained through differential voltage analysis (DVA), or during low C-rate charging (or more specifically the incremental capacity analysis (ICA)). The ICA involves estimating the change of capacity with respect to the voltage and analyzing the changes and positions of features of interest in the plot, such as plateaus, or peak height and their location. The information indicative of the voltage response may be represented by a set of discrete values. More specifically by a vector comprising a number of samples within a certain voltage window. The information indicative of the voltage response may be a discretized incremental capacity (IC) curve.

The method 100 further comprises obtaining S104 information indicative of a voltage response of a pristine battery cell. Put differently, the same type of information obtained for the degraded battery cell may be obtained also for the pristine battery cell. The information indicative of the voltage response of the pristine battery cell may also be referred to as "pristine voltage response" or "healthy voltage response", for ease of reference.

The degraded battery cell and the pristine battery cell is of a same battery specification. By battery specification, it is herein meant any technical properties that define the characteristics and performance capabilities of a battery cell. The battery specification may for instance comprise structural properties or configurations, such as the type of materials used in the battery (including e.g. active anode and cathode materials). The battery specification may further comprise a capacity of the battery cell, a nominal voltage, etc. Two batteries being of the same battery specification may thus be understood as them having the same manufacturing specification, or even that they are from the same manufacturing batch.

In a specific case, the degraded battery cell and the pristine battery cell may be the same battery cell, but at different states of its lifetime. More specifically, the pristine battery cell may be the degraded battery cell, but before is was put in use (i.e. when it was in pristine condition). In such case, the healthy voltage response may be obtained before, or at a start of using the battery cell. The healthy voltage response may then be stored for later, when the battery cell is to be diagnosed.

The method 100 further comprises processing S106 the information indicative of the voltage response of the degraded battery cell through a one-dimensional convolutional neural network, thereby generating a first output. In other words, the degraded voltage response may be fed to the one-dimensional convolutional neural network, which is configured to generate the first output. The output of the one-dimensional (1D) convolutional neural network can be seen as a feature vector (or feature map) generated from the input data. The output is produced after applying a set of convolutional layers (or filters thereof) of the convolutional neural network to the input data. For 1D convolutional layers, the filters are applied across a single dimension, such as a sequence or series of data points. Thus, the first output may be a one-dimensional vector.

The method 100 further comprise processing S108 the information indicative of the voltage response of the pristine battery cell through the one-dimensional convolutional neural network, thereby generating a second output. In other words, the degraded voltage response and the healthy voltage response are processed individually through the same convolutional neural network. Thus, the convolutional layers applied to the voltage responses have the same set of parameters (e.g. in terms of filter size, stride, etc.).

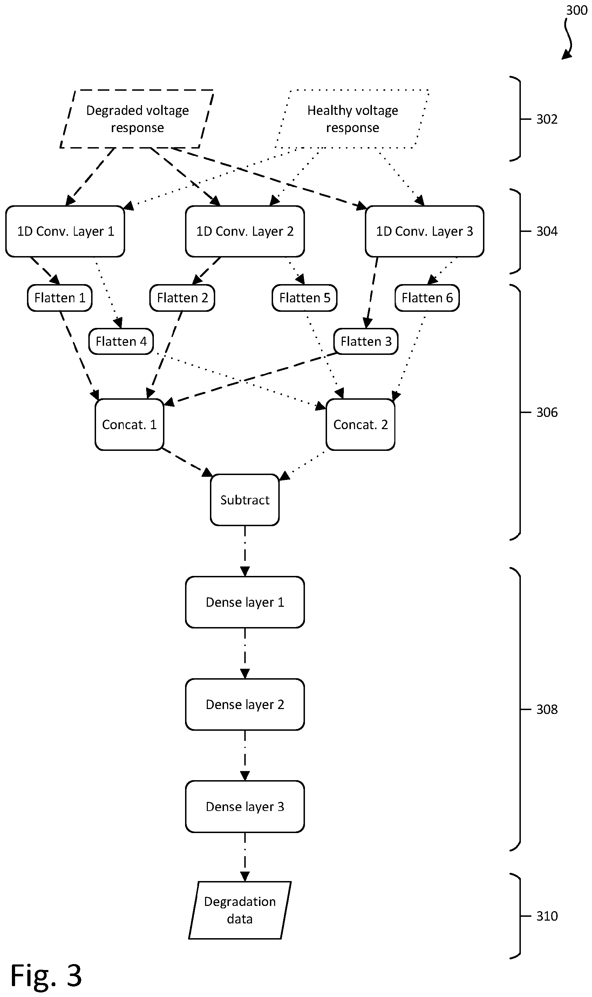

The one-dimensional convolutional neural network may comprise any number of convolutional layers. The one or more convolutional layers of the convolutional neural network may be arranged in parallel, e.g. as seen in Fig. 3. As one example, the 1D convolutional neural network may comprise a single convolutional layer, which is applied to the input data. However, in another example, the 1D convolutional neural network may comprise two or more convolutional layers. The two or more convolutional layers may be different from each other, e.g. in terms of kernel size, stride, etc. The voltage response of the degraded battery cell may then be processed through each of the two or more convolutional layers, thereby generating a respective first sub-output. In other words, each of the two of more convolutional layers may be applied to the degraded voltage response, to generate the respective first sub-output. Thus, each convolutional layer may generate a respective first sub-output. The first output may then be a combined output of the respective first sub-outputs from the two or more convolutional layers. In other words, the first output generated by the 1D convolutional neural network may be a combined output of the sub-outputs generated by the respective convolutional layers. The first sub-outputs may then be flattened and concatenated to form the first output. For further details of the 1D convolutional neural network, reference is made to below, in particular in connection with Fig. 3.

As with the degraded voltage response, the healthy voltage response may be processed through the two or more convolutional layers, in the case of a 1D convolutional neural network comprising more than one layer. Thus, the voltage response of the pristine battery cell may be processed through each of the two or more convolutional layers, thereby generating a respective second sub-output. The second output may be a combined output of the respective second sub-outputs from the two or more convolutional layers.

The method 100 further comprises forming S110 a difference between the first output and the second output. The difference may thus be formed between the feature vector extracted from the degraded voltage response and the feature vector extracted from the healthy voltage response. More specifically, the difference may be formed S112 by element-wise subtraction between the first output and the second output. In other words, the formed difference can be a new feature vector, where each element is the difference between the corresponding elements of the first output and the second output.

The method 100 further comprises determining S112 degradation data indicative of a degradation of the degraded battery cell by processing said difference through a mathematical model. The degradation data may be determined S112 as the direct output from the mathematical model. In other words, the degradation data may be the output of the mathematical model. Alternatively, the degradation data may be derived by further processing of the output of the mathematical model.

The mathematical model is configured to process data of input differences between a first battery cell and a second battery cell, and to generate degradation data of the first battery cell as output. In other words, the mathematical model is configured to receive the difference formed between the first and second output of the 1D convolutional neural network, and to output any data from which the degradation data can be derived. The wording "configured to" in this context can mean being "trained to", in case of a learned mathematical model. In a case of non-learned mathematical models, it can mean being set up in any other way to be able to generate said output. Example of such ways are statistical-based models or other nonlinear function approximation methods. As another example, the mathematical model may be some form of regression model.

The mathematical model may be configured to process data of battery cells having different cell configurations within a certain chemistry type. By chemistry type, it is herein meant a type of electrode active material. As an example, the chemistry type may be one of Nickel-manganese-cobalt (NMC), Nickel-cobalt-aluminum (NCA) or Lithium-iron-phosphate (LFP). In other words, the mathematical model may be configured to handle battery cells of different cell configurations, as long as they belong to the chemistry type which the mathematical model is set or trained to handle. The mathematical model may then be trained on one or more cell configurations of the same chemistry type.

The mathematical model (or algorithm) may be any suitable learned or non-learned model. Gaussian process regression, random forests, and symbolic regression are some examples of non-learned mathematical models.

As an example of a learned mathematical model, is a machine learning model. The mathematical model may be any suitable type of machine learning model. More specifically, the mathematical model may be a neural network. The neural network may comprise an input layer, one or more fully connected layers, and an output layer. Thus, the degradation data may be determined by processing the difference between the first and second output through the neural network, trained to generated a corresponding output from which the degradation data can be determined. For further details regarding the neural network, reference is made to Fig. 3 below.

In the case of a learned mathematical model, the one-dimensional convolutional neural network and the mathematical model may be trained together in an end-to-end manner. In other words, the model (herein referring to the entire processing pipeline, as exemplified in Fig. 3 below) may be trained and optimized in its entirety, from input to output. I.e. trained as a while in a single process.

The degradation data may be indicative of a state of health of the degraded battery cell. The state of health shall in the present context be understood as an overall metric of the health of the battery. For example, the state of health (SoH) may indicate a remaining capacity of the battery cell, relative an initial capacity of said battery cell. However, the SoH may also be related to an intolerable impedance rise of the battery, or any other property which can indicate the health of the battery cell.

Alternatively, or in combination, the degradation data may be indicative of one or more aging modes of the degraded battery cell. In some embodiments, the state of health of the battery may be derived from the aging modes.

Aging modes of the battery cell shall herein be understood as representations of specific aging mechanisms associated with the battery cell. An aging mode may for instance be an amount of lost active anode material, an amount of lost cathode material, or an amount of lost lithium inventory. The loss of such materials can happen as a result of chemical and physical factors that naturally causes the aging and degradation of batteries. Some examples of such factors are particle cracking, corrosion, lithium plating, gas evolution, undesired reactions, SEI dissolution or growth, etc.

The method 100 may further comprise providing S114 the determined degradation data to a downstream task. As an example, a signal indicative of the determined degradation data may be transmitted to a system (or device) configured to perform said downstream task. The degradation data may for instance be provided to a battery management system (BMS). The BMS may for example use the state-of-health to make a better estimation of a state-of-charge of the battery cell. In another example, the state-of-health may be used to make a prognosis for the remaining life of the battery cell. In yet another example, an evolution of the aging modes of the battery cell may be used for better prognosis or remaining useful lifetime estimations. As yet another example, the ageing mode prognosis can predict hidden capacity loss phenomena and describe sudden drops in capacity. For example, loss of active material may not be picked up by a SOH based prediction, while making a prognosis based on ageing modes, a future rapid loss of capacity can be predicted. The ageing mode analysis can then be used for matching packs, modules, or cells for second life applications, where inhomogeneities are undesirable.

As further examples, the signal may be transmitted to a User Interface (Ul) for displaying the state-of-health to a user of the battery, or to a warning system for indicating when to replace battery or for notifying user of faulty batteries.

Executable instructions for performing these functions are, optionally, included in a non-transitory computer-readable storage medium or other computer program product configured for execution by one or more processors.

Generally speaking, a computer-accessible medium may include any tangible or non-transitory storage media or memory media such as electronic, magnetic, or optical media-e.g., disk or CD/DVD-ROM coupled to computer system via bus. The terms "tangible" and "non-transitory," as used herein, are intended to describe a computer-readable storage medium (or "memory") excluding propagating electromagnetic signals, but are not intended to otherwise limit the type of physical computer-readable storage device that is encompassed by the phrase computer-readable medium or memory. For instance, the terms "non-transitory computer-readable medium" or "tangible memory" are intended to encompass types of storage devices that do not necessarily store information permanently, including for example, random access memory (RAM). Program instructions and data stored on a tangible computer-accessible storage medium in non-transitory form may further be transmitted by transmission media or signals such as electrical, electromagnetic, or digital signals, which may be conveyed via a communication medium such as a network and/or a wireless link.

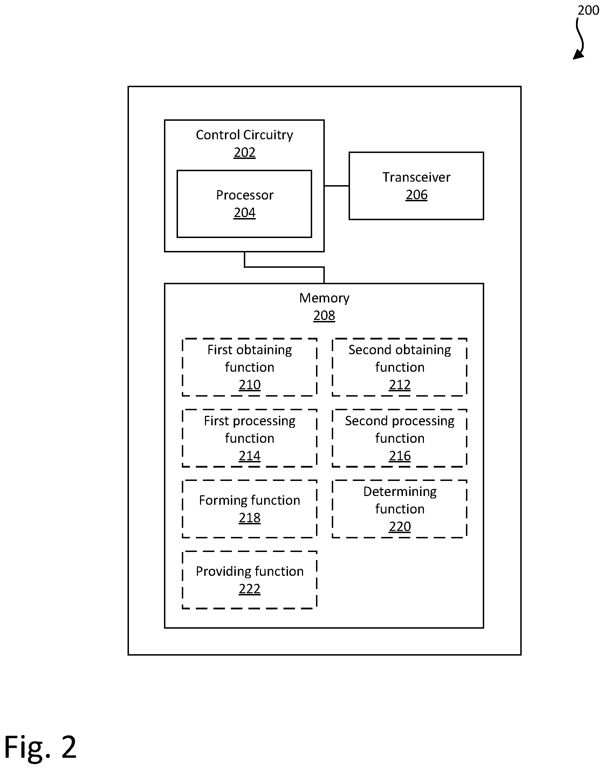

Figure 2 is a schematic illustration of a device 200 for degradation diagnosis of a degraded battery cell. In particular, the device 200 is configured to perform the techniques of the method 100 described in the foregoing with reference to Fig. 1. The device 200 refers to any general computing device, and may be provided as a stand-alone device, or incorporated in a larger device (i.e. a device which is not limited to perform only the described method 100).

The device 200 comprises control circuitry 202. The control circuitry 202 may physically comprise one single circuitry device. Alternatively, the control circuitry 202 may be distributed over several circuitry devices. As an example, the device 200 may share its control circuitry 202 with other devices. In another example, the device 200 may be incorporated as part of a battery management system (BMS) of whatever device is powered by the battery cell, such as an electric vehicle or any other battery-powered devices. Alternatively, the device 200 may be provided as a remote entity from the electric vehicle (or other battery powered device), such as a remote server or cloud-implemented service. In such case, the information indicative of the voltage response of the degraded battery cell may be transmitted from the electric vehicle, and received by the device 200.

As shown in the example of Fig. 2, the device 200 may further comprise a transceiver 206 and a memory 208. The control circuitry 202 being communicatively connected to the transceiver 206 and the memory 208. The control circuitry 202 may comprise a data bus, and the control circuitry 202 may communicate with the transceiver 206 and/or the memory 208 via the data bus.

The control circuitry 202 may be configured to carry out overall control of functions and operations of the device 200. The control circuitry 202 may include a processor 204, such as a central processing unit (CPU), microcontroller, or microprocessor. The processor 204 may be configured to execute program code stored in the memory 208, in order to carry out functions and operations of the device 200. The control circuitry 202 is configured to perform the steps of the method 100 as described above in connection with Fig. 1. The steps may be implemented in one or more functions stored in the memory 208. It should be noted that the various function and operation of the device 200 may be implemented in additional functions than those described herein. In addition, one or more of the above functions may be implemented together in a common function.

The transceiver 206 may be configured to enable the device 200 to communicate with other devices. The transceiver 206 may both transmit data from and receive data to the device 200. For example, the device 200 may obtain data (such as voltage responses) from sensors, storage mediums, or any other devices. Further, the device 200 may transmit data to other or systems connected to the device 200, such as providing the degradation data to a downstream task.

The memory 208 may be a non-transitory computer-readable storage medium. The memory 208 may be one or more of a buffer, a flash memory, a hard drive, a removable media, a volatile memory, a non-volatile memory, a random access memory (RAM), or another suitable device. In a typical arrangement, the memory 208 may include a non-volatile memory for long term data storage and a volatile memory that functions as system memory for the device 200. The memory 208 may exchange data with the circuitry 202 over the data bus. Accompanying control lines and an address bus between the memory 208 and the circuitry 202 also may be present.

Functions and operations of the device 200 may be implemented in the form of executable logic routines (e.g., lines of code, software programs, etc.) that are stored on a non-transitory computer readable recording medium (e.g., the memory 208) of the device 200 and are executed by the circuitry 202 (e.g. using the processor 204). Put differently, when it is stated that the circuitry 202 is configured to execute a specific function, the processor 204 of the circuitry 202 may be configured execute program code portions stored on the memory 208, wherein the stored program code portions correspond to the specific function. Furthermore, the functions and operations of the circuitry 202 may be a stand-alone software application or form a part of a software application that carries out additional tasks related to the circuitry 202. The described functions and operations may be considered a method that the corresponding device is configured to carry out, such as the method 100 discussed above in connection with Fig. 1. Also, while the described functions and operations may be implemented in software, such functionality may as well be carried out via dedicated hardware or firmware, or some combination of one or more of hardware, firmware, and software. In the following, the function and operations of the device 200 is described.

The control circuitry 202 is configured to obtain information indicative of a voltage response of the degraded battery cell. This may be performed e.g. by execution of a first obtaining function 210.

The control circuitry 202 is further configured to obtain information indicative of a voltage response of a pristine battery cell. The degraded battery cell and the pristine battery cell being of a same battery specification. This may be performed e.g. by execution of a second obtaining function 212. The first and second obtaining function 210, 212 may be implemented by a common obtaining function, as well as two separate functions.

The control circuitry 202 is further configured to process the information indicative of the voltage response of the degraded battery cell through a one-dimensional convolutional neural network, thereby generating a first output. This may be performed e.g. by execution of a first processing function 214.

The control circuitry 202 is further configured to process the information indicative of the voltage response of the pristine battery cell through the one-dimensional convolutional neural network, thereby generating a second output. This may be performed e.g. by execution of a second processing function 216. The first and second processing function 214, 216 may be implemented by a common obtaining function, as well as two separate functions.

The control circuitry 202 is further configured to form a difference between the first output and the second output. This may be performed e.g. by execution of a forming function 218.

The control circuitry 202 is further configured to determine degradation data indicative of a degradation of the degraded battery cell by processing said difference through a mathematical model. The mathematical model being configured to process data of input differences between a first battery cell and a second battery cell, and to generate degradation data of the first battery cell as output. This may be performed e.g. by execution of a determining function 220.

The control circuitry 202 may be further configured to provide the determined degradation data to a downstream task. This may be performed e.g. by execution of a providing function 222.

It should be noted that any principles, features, aspects, and advantages of the method 100 as described above in connection with Fig. 1, are applicable also to the device 200 described herein. In order to avoid undue repetition, reference is made to the above.

Figure 3 illustrates, by way of example, an architecture of a model 300, in accordance with some embodiments. The model 300 herein encompass the complete processing pipeline of the method 100 described above. The model 300 thus comprises both the one-dimensional convolutional neural network and the mathematical model as referred to above. Moreover, some intermediate steps are also represented by additional blocks. Each block thus represents some kind of processing step of the data input to said block, to generate a corresponding output. The arrows depicted herein represents the dataflow through the model 300, i.e. the inputs and outputs of each block. It is to be appreciated that the architecture of the model 300 merely serves as one example realization, and shall not be seen as limiting the scope of the present disclosure. As explained in the foregoing, other architectures may also be used. As an example, the part corresponding to the mathematical model (herein shown as a neural network), may be formed by any suitable combinations of layers. Moreover, the functions of the different blocks may be distributed differently. For example, two or more blocks depicted herein may be combined to a common block for performing the joint functions of the blocks. As another example, a block depicted herein may be divided into two or more sub-blocks for performing different parts of said block.

Looking now at Fig. 3, the model 300 comprises an input layer 302. At the input layer 302, the information indicative of the voltage response of the degraded battery cell (i.e. the degraded voltage response) and the information indicative of the voltage response of the pristine battery cell (i.e. the healthy voltage response) is received (i.e. corresponding to the steps denoted S102 and S104 in Fig. 1). The degraded voltage response and the healthy voltage response may for example be input as discretized IC curves, i.e. a respective vector of a finite number of samples. The input may thus have the shape of 1 times the number of samples.

For illustrative purposes, the dataflows of the two inputs are separated by different types of lines. More specifically, the degraded voltage response and corresponding dataflow is shown in dashed lines, while the healthy voltage response and corresponding dataflow is shown in dotted lines. The two inputs can be processed individually, either one after the other, or (at least partially) in parallel. When eventually combined, the dataflow is represented by a dash-dotted line.

During training, the model 300 may be trained on training instances of a single cell specification. More specifically, the same healthy voltage response may be used in combination with different instances of degraded voltage responses. This can provide for a simplified training procedure, as the healthy voltage response can be constant. During testing or inference, the model may be applied to cells of other specifications as well. Then, the second input (i.e. the healthy voltage response) may be changed to whatever new cell is to be diagnosed. In other words, if the model is used to diagnose cells of other specifications than what the model 300 has been trained on, the trained model can remain the same, but the healthy voltage response input is changed accordingly. This can then mean that the need for retraining the model 300 to be able to apply it to different cell specification (e.g. due to being manufactured differently because of tolerances, or different design choices, but within the same chemistry, i.e. same anode and cathode active materials) can be removed. It is however to be noted that the model 300 may also be trained on training instances of a number of different cell specifications. This can further help to improve its generalizability.

The model 300 further comprises a one-dimensional convolutional neural network 304. As explained in the foregoing, the 1D convolutional neural network 304 may comprise one or more 1D convolutional layers. In the illustrated example, the convolutional neural network 304 comprises three 1D convolutional layers (in Fig. 3 denoted "1D Conv. Layer 1" to "1D Conv. Layer 3"). Both inputs are processed independently by the three parallel 1D convolutional layers (i.e. corresponding to the steps denoted S106 and S108 in Fig. 1). The convolutional layers may have different properties. For example, they can have different kernel sizes. More specifically, each convolutional layer may comprise one or more filters (also referred to as kernels). The filters can be seen as numerical matrices or vectors of learnable parameters, that are used to extract features in the input data. In one example, each convolutional layer may comprise 10 filters. The size of the filters is what is referred to as kernel size above.

By processing the data through two or more convolutional layers may further improve the model's robustness and capability of detecting features of various sizes. Padding and stride may be set depending on the input size and kernel size.

A single level of convolutional layers (i.e. the convolutional neural network having a depth of 1) has been found to be sufficient, since the features of interest are relatively simple compared to more complex applications such as image recognition. However, an architecture of stacked convolutional layers (i.e. two or more convolutional layers in series) may still be used as well.

It is to be noted that the 1D convolutional neural network 304 used for the two inputs is the same. In other words, the two inputs are processed by the same 1D convolutional layers. This is because the healthy voltage response, by definition, contains no information regarding the degradation of the battery cell. If each input had its own 1D convolutional neural network, the weights on the healthy input side could be optimized to 0 and have no further impact on the model as a whole, making it learn solely on the degraded voltage response, and reduce the generalization capability otherwise achieved by the disclosed technology. It is however to be noted that the two inputs need not to be processed by the exact same instance of 1D convolutional neural network, as is can also be processed by two separate instances of the same 1D convolutional neural network.

The convolutional neural network 304 then outputs a feature vector (or feature map) for each processed signal.

The model 300 further comprises a subtraction layer 306. The subtraction layer 306 being configured to form the difference between the degraded voltage response and the healthy voltage response as processed through the 1D convolutional neural network 304 (i.e. corresponding to the step denoted S110 in Fig. 1).

Depending on the specific architecture, the outputs coming from the three 1D convolutional layers may first be flattened into 1D, herein through flattening blocks denoted "Flatten 1" to "Flatten 6". These blocks may also be implemented as one common flattening block. The flattened outputs associated with the degraded voltage response and the healthy voltage response may then be concatenated, e.g. through a respective first and second concatenation blocks (in Fig. 3 denoted "Concat. 1" and "Concat. 2"). Lastly, the difference can be formed, e.g. by feeding the two concatenated outputs to a subtraction block (in Fig. 3 denoted "Subtract"). The formed difference can then be a vector representing the difference (or change) of the features of interest in the voltage response, as suffered by the degraded state (compared to the pristine state). It can be noted that the subtraction layer 306 does not comprise any trainable parameters. Moreover, the setup of the subtraction layer 306 is dependent on the output size, and number of, 1D convolutional layers of the convolutional neural network 304. Thus, the actual implementation may vary depending on a specific realization.

The model 300 further comprises the mathematical model, as referred to above, herein represented as a fully connected layer 308. In other words, the mathematical model in this example illustration is a neural network.

The fully connected layer 308 herein comprises three sequential dense layers (in Fig. 3 denoted by "Dense layer 1" to "Dense layer 3"). The number of neurons of each dense layer may be set based on the size of the difference output from the subtraction layer 306, and a desired output size of the fully connected layer 308. Any suitable activation function may be used, such as ReLU, Sigmoid, Softmax, etc. The first dense layer may correspond to an input layer of the fully connected layer 308.

Lastly, the model 300 comprises an output layer 310, for providing the degradation data of the degraded battery cell. The output of the model may be achieved through a last dense layer, with a number of neurons equal to the number of outputs of the model 300. For example, in a case where the model 300 is configured to output a prediction/estimation of one or more aging modes of the battery cell, the final dense layer may comprise an equal number of neurons, i.e. one for each aging mode.

In a specific example, the output layer 310 may generate an output representing a degradation in terms of an amount of lost active anode material, an amount of lost cathode material, and an amount of lost lithium inventory, e.g. as a percentage of their initial value. In another example, the last dense layer comprises one neuron, generating an output representing the current state of health of the battery cell, e.g. as a percentage of remaining capacity, relative to the initial capacity.

Training of the model 300 as described herein may be done in an end-to-end manner. In other words, the convolutional neural network 304 and the fully connected layer 308 may learn its trainable parameters during a common training procedure. Training can be done using synthetic data generated based on a digital twin of the battery cell, which can replicate the battery cell's behavior under certain degradation conditions. It has been found that even if the model 300 is trained on just a single battery cell specification, it can still generalize to other cell configurations, within the same chemistry type, and provide accurate prediction also for these.

The disclosed technology has been presented above with reference to specific embodiments. However, other embodiments than the above described are possible and within the scope of the invention. Different method steps than those described above, performing the methods by hardware or software, may be provided within the scope of the invention. Thus, according to an exemplary embodiment, there is provided a non-transitory computer-readable storage medium storing one or more programs configured to be executed by one or more processors of a vehicle control system, the one or more programs comprising instructions for performing the methods according to any one of the above-discussed embodiments. Alternatively, according to another exemplary embodiment a cloud computing system can be configured to perform any of the methods presented herein. The cloud computing system may comprise distributed cloud computing resources that jointly perform the methods presented herein under control of one or more computer program products.

It should be noted that any reference signs do not limit the scope of the claims, that the invention may be at least in part implemented by means of both hardware and software, and that the same item of hardware may represent several "means" or "units".

## Claims

1. A computer-implemented method (100) for degradation diagnosis of a degraded battery cell, the method (100) comprising:
obtaining (S102) information indicative of a voltage response of the degraded battery cell;
obtaining (S104) information indicative of a voltage response of a pristine battery cell, wherein the degraded battery cell and the pristine battery cell is of a same battery specification;
processing (S106) the information indicative of the voltage response of the degraded battery cell through a one-dimensional convolutional neural network, thereby generating a first output;
processing (S108) the information indicative of the voltage response of the pristine battery cell through the one-dimensional convolutional neural network, thereby generating a second output;
forming (S110) a difference between the first output and the second output; and
determining (S112) degradation data indicative of a degradation of the degraded battery cell by processing said difference through a mathematical model, wherein the mathematical model is configured to process data of input differences between a first battery cell and a second battery cell, and to generate degradation data of the first battery cell as output.

2. The method (100) according to claim 1, wherein the one-dimensional convolutional neural network comprises two or more convolutional layers.

3. The method (100) according to claim 2, wherein the voltage response of the degraded battery cell is processed through each of the two or more convolutional layers, thereby generating a respective first sub-output, and
wherein the first output is a combined output of the respective first sub-outputs from the two or more convolutional layers.

4. The method (100) according to claim 2 or 3, wherein the voltage response of the pristine battery cell is processed through each of the two or more convolutional layers, thereby generating a respective second sub-output, and
wherein the second output is a combined output of the respective second sub-outputs from the two or more convolutional layers.

5. The method (100) according to any one of the claims 1 to 4, wherein the difference is formed (S112) by element-wise subtraction between the first output and the second output.

6. The method (100) according to any one of the claims 1 to 5, wherein the mathematical model is a machine learning model.

7. The method (100) according to any one of the claims 1 to 6, wherein the mathematical model is a neural network, and wherein the neural network comprises an input layer, one or more fully connected layers, and an output layer.

8. The method (100) according to any one of the claims 1 to 7, wherein the mathematical model is configured to process data of battery cells having different cell configurations within a certain chemistry type.

9. The method (100) according to any one of the claims 1 to 8, wherein the one-dimensional convolutional neural network and the mathematical model are trained together in an end-to-end manner.

10. The method (100) according to any one of the claims 1 to 9, wherein the degradation data is indicative of a state of health of the degraded battery cell.

11. The method (100) according to any one of the claims 1 to 10, wherein the degradation data is indicative of one or more aging modes of the degraded battery cell.

12. The method (100) according to any one of the claims 1 to 11, wherein the one or more aging modes comprises (i) an amount of lost active anode material, (ii) an amount of lost cathode material, and (iii) an amount of lost lithium inventory.

13. The method (100) according to any one of the claims 1 to 12, further comprising providing (S114) the determined degradation data to a downstream task.

14. A computer program product comprising instructions which, when the program is executed by a computing device, causes the computing device to carry out the method (100) according to any one of claims 1 to 13.

15. A device (200) for degradation diagnosis of a degraded battery cell, the device (200) comprising control circuitry (202) configured to:
obtain information indicative of a voltage response of the degraded battery cell;
obtain information indicative of a voltage response of a pristine battery cell, wherein the degraded battery cell and the pristine battery cell is of a same battery specification;
process the information indicative of the voltage response of the degraded battery cell through a one-dimensional convolutional neural network, thereby generating a first output;
process the information indicative of the voltage response of the pristine battery cell through the one-dimensional convolutional neural network, thereby generating a second output;
form a difference between the first output and the second output; and
determine degradation data indicative of a degradation of the degraded battery cell by processing said difference through a mathematical model, wherein the mathematical model is configured to process data of input differences between a first battery cell and a second battery cell, and to generate degradation data of the first battery cell as output.
